# EUROPEAN PATENT SPECIFICATION

(11) **EP 4 325 728 B1**
(45) Date of publication and mention of the grant of the patent: **06.08.2025**
(21) Application number: 22382789.0
(22) Date of filing: 18.08.2022
(51) Int. Cl.: H04B 3/00, G01R 31/00

(54) **WIRING TEST DEVICE AND PROCESS FOR HIGH SPEED DATA COMMUNICATIONS IN VEHICLES**
VERDRAHTUNGSTESTGERÄT UND -VERFAHREN FÜR HOCHGESCHWINDIGKEITSDATENKOMMUNIKATION IN FAHRZEUGEN
DISPOSITIF ET PROCÉDÉ DE TEST DE CÂBLAGE POUR LES COMMUNICATIONS DE DONNÉES À HAUT DÉBIT DANS LES VÉHICULES

(43) Date of publication of application: 21.02.2024
(73) Proprietor: EMDEP 2, S.L., 43813 Alió (Tarragona) (ES)
(72) Inventor: MARTÍNEZ ZAMBRANA, Juan Antonio, 43813 Alió (Tarragona) (ES)
(74) Representative: Pons IP

(56) References cited:
- CN-U- 205 506 985
- CN-U- 214 621 512

## Description

### OBJECT OF THE INVENTION

The object of the present invention is a device and process of special application in the technological field of electronic engineering, specifically in the field of measuring parameters of twisted wire pairs.

Specifically, it relates to a wiring test device and process for high speed communications, particularly applicable to automobile wiring, which obtains the parameters of the frequency response of the wire under test and based on theoretical preset parameters to determine whether said wire or set of wires meet the functionality requirements, carrying out the measurement process on an industrial workbench.

### BACKGROUND OF THE INVENTION

The number of high speed communications and data buses required in a car has grown exponentially and is expected to continue to do so in the coming years. Consequently, the wires for this purpose must be validated based on compliance with a certain frequency behaviour that ensures proper functioning of the communication between the devices installed in a vehicle.

The wires used for data flow are, for the most part, of two well-differentiated types: twisted pairs and coaxial pairs. There are in turn a wide variety of categories, terminations and connections, the features of which will determine its functionality and transmission capabilities, as well as its application. Of these two major groups, twisted pairs are the most widely used, covering most applications, and coaxial pairs are those which reach the highest speeds and bandwidth.

In addition, there are many typical automotive communication systems that are physically supported by twisted wires, such as Ethernet, CAN, FlexRay, etc.

Specifically, a twisted pair is essentially made up of two conductive wires insulated from each other and wound one on top of another in a helical manner. The aim of this winding is to cancel the common mode in the transmission and therefore shielding of external signals that are not to be transmitted.

Depending on the intended application or use of a twisted pair, it must meet certain minimum requirements to ensure the operation thereof, for example, in the case of the Open Alliance Ethernet 100BASE-T1 standard.

Either of the two types of wires described are subjected to a multitude of tests to verify their correct operation. Up to now, ethernet tests are carried out in a separate test station with special counterparts, where more types of tests on the wire in one same device cannot be carried out. Moreover, in general, equipment for testing frequency parameters is highly expensive.

Document CN205506985 describes a vehicle testing technology of electrical accessories. Additionally, document CN214621512 discloses an automobile dashboard connecting line test fixture. However, none of these devices allows to determine if a wire of an electrical vehicle meets the existing standards regardless of its type.

### DESCRIPTION OF THE INVENTION

The object of the present invention is a wiring test device and process for high speed communications (HSD, High Speed Data). The wiring is preferably wiring used in vehicles, which can be twisted or coaxial pairs. Regardless of the type of wire to be tested, the device and process of the invention enable criteria of expected frequency response to be set based on existing standards.

The purpose of the invention is to enable an operator within the field of production to carry out a quality control of wires for vehicles, based on a series of predefined parameters, on a test bench or workbench, thus reducing production times and increasing the quality of said wires, without causing unnecessary losses.

The present invention is defined by the attached independent claims. Other preferred embodiments may be found in the dependent claims. The present application discloses a wiring test method for high speed data communications in vehicles, which makes use of a wiring test device that comprises: a workbench (1), counterparts (6), arranged on the workbench (1), comprising the counterparts (6) connectors (7), adapted to be connected to both ends of one or more wires (2) to be analysed, a wire electrification module (4), linked to the connectors (7), adapted to inject a high frequency signal in the wires (2), a data measurement and processing module (3), linked to the connectors (7), adapted to pick up the high frequency signal that circulates through the wires (2), a power supply module (9) for the measurement and processing module (3) and for the electrification module (4), and- a data display module (5), linked to the measurement and processing module (3), being the method characterized in that it comprises the steps of: connecting one or more wires (2) to be analysed to the connectors (7) of the counterparts (6), verifying the correct connection of the wires (2) to the connectors (7) arranged on the workbench (1), injecting the high frequency signal in the wires (2) with the electrification module (4), reading the high frequency signal once it has passed through the wires (2) with the measurement and processing module (3), determining one or more of the following parameters: distance to a preset insertion loss (IL) limit, distance to a preset return loss (RL) limit, distance to a preset longitudinal conversion loss (LCL) limit, distance to a preset longitudinal conversion transfer loss (LCTL) limit, absolute value of the time domain reflectometry impedance (TDR Z), characteristic impedance differential mode (CIDM) and sending, to the display module (5), the parameters obtained.

Optionally, the process may comprise a step of generating graphs of the parameters along the wire.

The limit values of each of the parameters can vary depending on the selection of the standards used (MS DWCAN, HS DWCAN, diagnostic CAN, high speed CAN, FlexRay, etc.).

The high frequency signal can be injected in pulse mode, to see specific changes in impedance and look for defects, or in continuous mode, to see the characteristic impedance along the entire wire.

### DESCRIPTION OF THE DRAWINGS

As a complement to the description provided herein, and for the purpose of helping to make the features of the invention more readily understandable, in accordance with a preferred practical exemplary embodiment thereof, said description is accompanied by a set of drawings constituting an integral part of the same, which by way of illustration and not limitation, the following has been represented:
Figure 1 shows a schematic representation of the wiring test device for high speed data communications in vehicles.
Figure 2 shows a schematic representation of the counterparts of the device.

### PREFERRED EMBODIMENT OF THE INVENTION

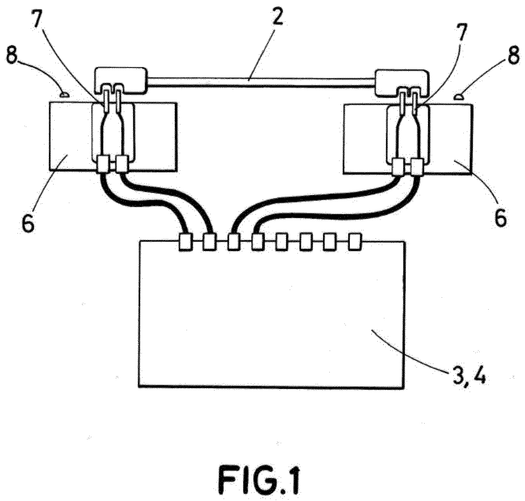

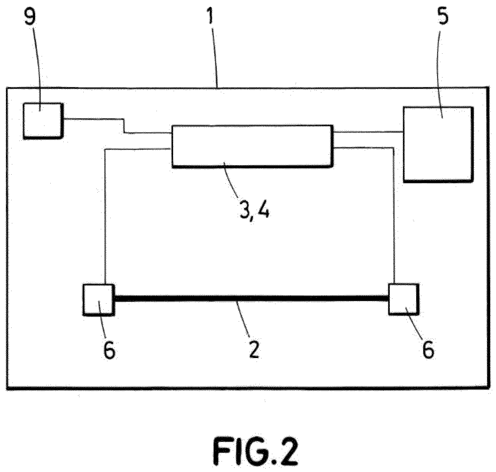

A preferred embodiment of the wiring test device and process for high speed data communications in vehicles is described below, with the help of Figures 1 and 2.

As shown in detail in Figure 1, the device of the invention comprises, firstly, a workbench (1), which serves as a support for the rest of the elements of the device. On the workbench (1), an operator will be able to test wires (2) quickly and easily, and the workbench (1) can be fixed or portable.

Arranged on the workbench (1), the device comprises a data measurement and processing module (3) powered by a power supply module (9), configured to pick up a current that circulates through the wires (2), process it, and obtain a set of variables of interest.

Also linked to the workbench (1), the device comprises a wire (2) electrification module (4), designed to inject a high frequency signal in the wires (2) to be analysed.

In order to operate efficiently with the device, it further comprises a data display module (5), linked to the measurement and processing module (3), which shows different parameters to the operator, such as test results, values of the different parameters, or even graphs of the values of the parameters along the entire length of the wire (2).

Lastly, and to facilitate operability with the different types of wires (2) that can be analysed, the device comprises counterparts (6), connected to the electrification module (4) and to the measurement and processing module (3), intended to be connected to one or more wires (2) to be analysed (a wire is understood as each of the lines that make up the twisted pair or coaxial wire).

As shown in Figure 2, the counterparts (6) comprise connectors (7), intended to be connected to the wires (2) to be analysed, which can be adapted based on the type of wire (2) to be analysed. In addition, the connectors (7) are connected to the electrification module (4), to inject current in the wires (2), and to the measurement and processing module (3), to pick up the current once it has passed through the wires (2) and proceed to analyse it and obtain parameters of interest.

The counterparts (6) also comprise a retainer, which maintains the connection once the wire (2) is connected to the connectors (7), to ensure good contact.

In addition, the counterparts (6) comprise lighting units (8), such as LEDs, configured to indicate that the wires (2) are correctly connected to the connectors (7).

Moreover, the process of the invention makes use of the device described and comprises a first step of connecting the wires (2) to be analysed to the connectors (7) of the counterparts (6).

Next, the correct connection of the wires (2) to the connectors (7) is verified. This verification can be carried out, for example, by making a current circulate through the wires (2) and checking that it circulates correctly from end to end.

Then, a high frequency signal (preferably 0.1-3,000 MHz) is injected in the wires (2) and through the connectors and said high frequency signal is read once it has passed through the wires (2).

The next step consists of determining a set of parameters of interest, predefined by the operator, and which can be one or more of:
∘ distance to a preset insertion loss (IL) limit,
∘ distance to a preset return loss (RL) limit,
∘ distance to a preset longitudinal conversion loss (LCL) limit,
∘ distance to a preset longitudinal conversion transfer loss (LCTL) limit,
∘ absolute value of the time domain reflectometry impedance (TDR Z),
∘ characteristic impedance differential mode (CIDM),

If all the parameters obtained are correct (correct means that they are within a predetermined range (TDR Z, CIDM) or below a maximum limit (IL, RL, LCL, LCTL) along the entire wire), a correct wire (2) signal is generated.

On the contrary, if any of the parameters is not correct, an incorrect wire (2) signal is generated. In this case, a single pass/fail signal can be generated, or the specific parameter(s) that is(are) incorrect can be indicated.

Furthermore, the process may comprise a step of generating graphs of the parameters along the wire (2).

## Claims

1. A wiring test method for high speed data communications in vehicles, which makes use of a wiring test device that comprises:
- a workbench (1),
- counterparts (6), arranged on the workbench (1), comprising the counterparts (6) connectors (7), adapted to be connected to both ends of one or more wires (2) to be analysed,
- a wire electrification module (4), linked to the connectors (7), adapted to inject a high frequency signal in the wires (2),
- a data measurement and processing module (3), linked to the connectors (7), adapted to pick up the high frequency signal that circulates through the wires (2),
- a power supply module (9) for the measurement and processing module (3) and for the electrification module (4), and
- a data display module (5), linked to the measurement and processing module (3),
being the method **characterized in that** it comprises the steps of:
- connecting one or more wires (2) to be analysed to the connectors (7) of the counterparts (6),
- verifying the correct connection of the wires (2) to the connectors (7) arranged on the workbench (1),
- injecting the high frequency signal in the wires (2) with the electrification module (4),
- reading the high frequency signal once it has passed through the wires (2) with the measurement and processing module (3),
- determining one or more of the following parameters:
∘ distance to a preset insertion loss (IL) limit,
∘ distance to a preset return loss (RL) limit,
∘ distance to a preset longitudinal conversion loss (LCL) limit,
∘ distance to a preset longitudinal conversion transfer loss (LCTL) limit,
∘ absolute value of the time domain reflectometry impedance (TDR Z),
∘ characteristic impedance differential mode (CIDM),
- sending, to the display module (5), the parameters obtained.

2. The method of claim 1, wherein the high frequency signal is comprised in the range of 0.1-3,000 MHz.

3. The method of claim 1, further comprising the step of:
- if all the parameters are correct with respect to pre-established parameters, generating a correct wire (2) signal,
- if any of the parameters is not correct with respect to the pre-established parameters, generating an incorrect wire (2) signal.

4. The method of claim 1, further comprising a step of generating graphs of the parameters obtained along the wires (2) in the display module (5).

5. The method of claim 1, wherein the high frequency signal is injected in pulse mode.

6. The method of claim 1, wherein the high frequency signal is injected in continuous mode.

## Patentansprüche

1. Ein Leitungstestverfahren für Hochgeschwindigkeitsdatenkommunikation in Fahrzeugen, das eine Leitungstestvorrichtung verwendet, die Folgendes umfasst:
- eine Werkbank (1),
- auf der Werkbank (1) angeordnete Gegenstücke (6), wobei die Gegenstücke (6) Steckverbinder (7) umfassen, die ausgestaltet sind, um an beide Enden einer oder mehrerer zu analysierenden Leitungen (2) angeschlossen zu werden,
- ein mit den Steckverbindern (7) verbundenes Leitungselektrifizierungsmodul (4), das ausgestaltet ist, um ein Hochfrequenzsignal in die Leitungen (2) einzuspeisen,
- ein mit den Steckverbindern (7) verbundenes Datenmess- und - verarbeitungsmodul (3), das ausgestaltet ist, um das durch die Leitungen (2) fließende Hochfrequenzsignal abzugreifen,
- ein Stromversorgungsmodul (9) für das Mess- und Verarbeitungsmodul (3) und für das Elektrifizierungsmodul (4), und
- ein mit dem Mess- und Verarbeitungsmodul (3) verbundenes Datenanzeigemodul (5),
wobei das Verfahren **dadurch gekennzeichnet ist, dass** es die folgenden Schritte umfasst:
- Anschluss einer oder mehrerer zu analysierender Leitungen (2) an die Steckverbinder (7) der Gegenstücke (6),
- Überprüfung der korrekten Verbindung der Leitungen (2) mit den auf der Werkbank (1) angeordneten Steckverbindern (7),
- Einspeisen des Hochfrequenzsignals in die Leitungen (2) mit dem Elektrifizierungsmodul (4),
- Lesen des Hochfrequenzsignals, nachdem es die Leitungen (2) mit dem Mess- und Verarbeitungsmodul (3) durchlaufen hat,
- Bestimmung eines oder mehrerer der folgenden Parameter:
∘ Abstand zu einem voreingestellten Grenzwert für die Einfügedämpfung (IL),
∘ Abstand zu einem voreingestellten Grenzwert für die Rückflussdämpfung (RL),
∘ Abstand zu einem voreingestellten Grenzwert für die Längsumwandlungsdämpfung (LCL),
∘ Abstand zu einem voreingestellten Grenzwert für die Längsumwandlungsübertragungsdämpfung (LCTL),
∘ Absolutwert der Zeitbereichsreflektometrie-Impedanz (TDR Z),
∘ Charakteristische Impedanz im Differenzmodus (CIDM),
- Übermittlung der erhaltenen Parameter an das Anzeigemodul (5).

2. Verfahren nach Anspruch 1, wobei das Hochfrequenzsignal im Bereich von 0,1 bis 3.000 MHz liegt.

3. Verfahren nach Anspruch 1, wobei dieses ferner den folgenden Schritt umfasst:
- wenn alle Parameter in Bezug auf die vorgegebenen Parameter korrekt sind, wird ein Signal erzeugt, das anzeigt, dass die Leitung (2) korrekt ist,
- wenn einer der Parameter in Bezug auf die vorgegebenen Parameter nicht korrekt ist, wird ein Signal erzeugt, das anzeigt, dass die Leitung (2) nicht korrekt ist.

4. Verfahren nach Anspruch 1, wobei dieses ferner einen Schritt zur Erstellung von Diagrammen der entlang der Leitungen (2) erhaltenen Parameter im Anzeigemodul (5) umfasst.

5. Verfahren nach Anspruch 1, wobei das Hochfrequenzsignal gepulst eingespeist wird.

6. Verfahren nach Anspruch 1, wobei das Hochfrequenzsignal kontinuierlich eingespeist wird.

## Revendications

1. Procédé de test de câblage pour des communications de données à haut débit dans des véhicules, qui utilise un dispositif de test de câblage qui comprend :
- un établi (1),
- des contreparties (6), agencées sur l'établi (1), comprenant des connecteurs (7) des contreparties (6), adaptés pour être connectés aux deux extrémités d'un ou plusieurs fils (2) à analyser,
- un module d'électrification (4) de fil, relié aux connecteurs (7), adapté pour injecter un signal haute fréquence dans les fils (2),
- un module de mesure et de traitement (3) de données, relié aux connecteurs (7), adapté pour capter le signal haute fréquence qui circule à travers les fils (2),
- un module d'alimentation en puissance (9) pour le module de mesure et de traitement (3) et pour le module d'électrification (4), et
- un module d'affichage de données (5), relié au module de mesure et de traitement (3),
le procédé étant **caractérisé en ce qu'**il comprend les étapes consistant à :
- connecter un ou plusieurs fils (2) à analyser aux connecteurs (7) des contreparties (6),
- vérifier la connexion correcte des fils (2) aux connecteurs (7) agencés sur l'établi (1),
- injecter le signal haute fréquence dans les fils (2) avec le module d'électrification (4),
- lire le signal haute fréquence une fois qu'il est passé à travers les fils (2) avec le module de mesure et de traitement (3),
- déterminer un ou plusieurs des paramètres suivants :
∘ distance jusqu'à une limite de perte d'insertion (IL) prédéfinie,
∘ distance jusqu'à une limite de perte de retour (RL) prédéfinie,
∘ distance jusqu'à une limite de perte de conversion longitudinale (LCL) prédéfinie,
∘ distance jusqu'à une limite de perte de transfert de conversion longitudinale (LCTL) prédéfinie,
∘ valeur absolue de l'impédance de réflectométrie dans le domaine temporel (TDR Z),
o mode différentiel à impédance caractéristique (CIDM),
- envoyer, au module d'affichage (5), les paramètres obtenus.

2. Procédé selon la revendication 1, dans lequel le signal haute fréquence est compris dans la plage de 0,1 à 3 000 MHz.

3. Procédé selon la revendication 1, comprenant en outre l'étape consistant à :
- si tous les paramètres sont corrects par rapport aux paramètres préétablis, générer un signal de fil (2) correct,
- si l'un quelconque des paramètres n'est pas correct par rapport aux paramètres préétablis, générer un signal de fil (2) incorrect.

4. Procédé selon la revendication 1, comprenant en outre une étape consistant à générer des graphiques des paramètres obtenus le long des fils (2) dans le module d'affichage (5).

5. Procédé selon la revendication 1, dans lequel le signal haute fréquence est injecté en mode d'impulsions.

6. Procédé selon la revendication 1, dans lequel le signal haute fréquence est injecté en mode continu.
